# DEMANDE DE BREVET EUROPEEN

(11) **EP 1 296 446 A1**
(43) Date de publication de la demande: **26.03.2003**
(21) Numéro de dépôt: 02078819.6
(22) Date de dépôt: 17.09.2002
(51) Int. Cl.: H03D 7/14

(54) **Circuit de conversion linéaire de puissance**

(30) Priorité: 25.09.2001 FR 0112323
(71) Demandeur: Koninklijke Philips Electronics N.V., 5621 BA Eindhoven (NL)
(72) Inventeur: Le, Luan, c/o Société Civile S.P.I.D., 75008 Paris (FR)
(74) Mandataire: Chaffraix, Jean

(57) **Abrégé**

L'invention concerne un circuit de conversion pour convertir un signal de puissance différentiel II[1], II[2] en un courant de sortie différentiel IC[1], IC[2], ledit circuit incluant des moyens de conversion CONV et des moyens de régulation REG de l'impédance d'entrée du circuit reliés aux moyens de conversion CONV. Les moyens de régulation REG selon l'invention incluent des moyens de contre-réaction pour contrôler un courant de régulation IREG soustrait à chaque composante du signal de puissance II[1], II[2] en fonction des valeurs des potentiels V[1], V[2] aux entrées du circuit de conversion. La demi-somme entre les deux potentiels V[1], V[2] aux entrées du circuit est avantageusement utilisée pour guider la contre-réaction qui peut avantageusement être appliquée aux bases de transistors de régulation contrôlant la valeur du courant de régulation.

L'invention permet de réaliser des mélangeurs de grande précision et peut être mise en oeuvre dans tout appareil de traitement de signal utilisant des circuits de conversion de puissance et, en particulier, des mélangeurs.

## Description

L'invention concerne un circuit de conversion pour convertir un signal de puissance différentiel composé d'un premier signal fourni à un premier noeud commun et d'un second signal fourni à un second noeud commun, en un courant de sortie différentiel composé d'un premier et d'un second courant, ledit circuit incluant une première sortie fournissant le premier courant, une seconde sortie fournissant le second courant,
ledit circuit incluant :
des moyens de conversion pour convertir le premier et le second signal en le premier et le second courant respectivement, lesdits moyens de conversion étant reliés aux première et seconde sorties du circuit de conversion,
des moyens de régulation de l'impédance d'entrée du circuit reliés aux moyens de conversion.

L'invention concerne également le domaine des mélangeurs et plus généralement le domaine des circuits analogiques de traitement du signal.

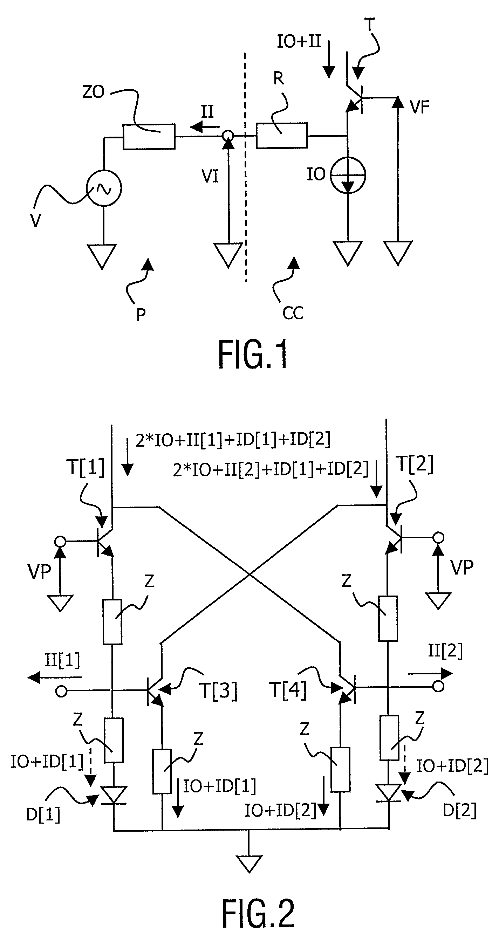

La cellule de conversion d'un signal en courant la plus simple met en oeuvre un transistor soumis à une polarisation et une résistance, tel que représenté sur la figure 1. La principale limitation est que, quel que soit le type de transistor utilisé, l'impédance d'entrée augmente fortement lorsque le courant dans le transistor diminue. C'est le cas lorsque la valeur absolue de II est proche de la valeur du courant de polarisation IO, ce qui est le cas à puissance élevée. Dans ce cas, un signal alternatif ne bénéficiera pas d'une impédance constante lors de la conversion, les valeurs négatives voyant une impédance plus élevée que les valeurs positives sur la période. Une solution coûteuse est d'augmenter le courant de polarisation. Pour éviter d'avoir à augmenter le courant de polarisation, une structure différentielle a été proposée par B. Gilbert dans le brevet US 6,122,497. Dans cette solution, le signal d'entrée et le courant de sortie sont différentiels. Le courant d'entrée II[1], respectivement II[2], passe par T[1], respectivement T[2], pendant son alternance positive et par D[1], respectivement D[2], pendant l'alternance négative. Les transistors T[1] et T[2] constituent les moyens de conversion alors que les diodes D[1] et D[2] constituent des moyens de régulation de l'impédance d'entrée dans la mesure où le courant circulant dans les diodes pendant l'alternance négative permet de définir limpédance d'entrée du circuit de conversion durant cette alternance négative. Des miroirs de courants permettent de renvoyer les courant dans les diodes à la sortie du circuit de conversion.

L'invention prend en considération un inconvénient de l'état de la technique selon lequel l'impédance d'entrée chute des deux côtés lorsque la puissance d'entrée augmente.

Un but de l'invention est de réduire la chute de l'impédance d'entrée lorsque la puissance d'entrée augmente. Par là, l'invention améliore la linéarité du circuit de conversion en terme d'impédance d'entrée.
En effet, un circuit conforme au paragraphe introductif est remarquable selon l'invention en ce que les moyens de régulation incluent des moyens de contre-réaction pour contrôler un courant de régulation soustrait à chaque composante du signal de puissance en fonction des valeurs des potentiels aux premier et second noeuds communs.
La soustraction d'un courant de régulation aux composantes du signal de puissance permet d'augmenter l'impédance d'entrée du côté de l'alternance négative alors qu'elle diminue du côté de l'alternance positive où la régulation n'a que peu d'influence sur la valeur de l'impédance d'entrée. Comme le circuit fonctionne en différentiel, les deux phénomènes se compensent laissant l'impédance globale constante.
Dans des modes de réalisation avantageux, les moyens de conversion et de régulation sont réalisés à l'aide de plusieurs transistors agencés d'une manière décrite plus loin pour laquelle certains d'entre eux sont bouclés pour réaliser une contre-réaction. Dans ce cas, la contre-réaction régule dynamiquement les polarisations des moyens de conversion de manière à en déplacer les points de fonctionnement. Cela se fait préférentiellement par application d'un potentiel de contre-réaction à un transistor qui fonctionne en générateur de courant.
Dans un mode de réalisation préféré les moyens de contre-réaction régulent le courant de régulation en fonction d'une valeur moyenne des potentiels aux premiers et seconds noeuds communs. Une contre-réaction de mode commun est donc réalisée. La valeur moyenne, somme des deux composantes du signal de puissance divisée par deux, influe sur les moyens de contre-réaction pour déterminer le courant de régulation.

Lorsque des transistors sont utilisés, l'utilisation d'une tension de mode commun pour générer une contre-réaction permet de contrôler le courant de régulation circulant dans les transistors des moyens de régulation. Dans le cadre de l'invention, l'impédance chute du coté de l'alternance positive et augmente du coté de l'alternance négative. L'impédance d'entrée différentielle étant la somme des deux impédances, les deux effets se compensent et permettent ainsi d'éviter la chute de l'impédance à forte puissance.
Des améliorations avantageuses sont proposées dans plusieurs modes de réalisation avantageux de l'invention pour optimiser les problèmes de bruit. Pratiquement, la présente invention concerne tous mélangeurs de signaux dans lesquels est mis en oeuvre un circuit selon l'invention. Tout mélangeur dit de type Gilbert nécessite en effet un circuit de conversion. Les mélangeurs sont utilisés dans les appareils de traitement de signaux dans lesquels des translations de fréquence sont réalisées : téléphone sans fil, téléphone de type DECT, téléphone mobile, récepteur satellite... L'invention concerne ainsi également de tels appareils de traitement du signal, le traitement du signal pouvant être réalisé à la réception, à l'émission ou à tout moment où cela est nécessaire.
De la même manière l'invention concerne les appareils de mesure d'impédance et de fréquence utilisant un circuit de conversion selon l'invention au sein ou non d'un mélangeur.

L'invention sera décrite ci-après plus en détail par référence aux figures annexées parmi lesquelles :
la figure 1 est un schéma d'un circuit de conversion tel qu'utilisé de manière standard,
la figure 2 est un schéma d'un circuit de conversion tel que proposé dans l'état de la technique cité,
la figure 3 est un diagramme schématique de l'invention,
la figure 4 est un schéma d'un circuit de conversion selon une mise en oeuvre particulièrement simple de l'invention,
la figure 5 est un diagramme de polarisation d'une cellule de conversion illustrant l'évolution de l'impédance d'entrée,
la figure 6 propose une comparaison graphique entre les propriétés d'une cellule de conversion selon l'état de la technique et celles d'une cellule selon l'invention,
les figures 7 à 9 sont des schémas de mise en oeuvre améliorée de cellules de conversion selon l'invention.

Dans les circuits intégrés, le signal véhiculant l'information est soit une tension, soit un courant. Cependant dans beaucoup d'applications comme la télécommunication, le signal d'entrée est une puissance. Il est alors nécessaire de transformer la puissance d'entrée en courant afin de pouvoir traiter l'information. Ainsi, un circuit de conversion est utile pour tout type de circuit manipulant le courant. Par exemple, les circuits de mesure de puissance, les circuits de mesure d'impédance sont de tels circuits. C'est aussi notamment le cas des mélangeurs qui réalisent des translations de fréquences en utilisant des circuits de conversion. Une des caractéristiques importantes des circuits de conversion est leur linéarité, tant au niveau de la conversion de puissance que de l'impédance d'entrée. En effet, la linéarité de l'impédance d'entrée assure une bonne adaptation d'impédance permettant de maximiser le gain et minimiser le bruit. Ainsi, quelle que soit la puissance d'entrée, les propriétés suivantes sont recherchées : impédance d'entrée constante quelle que soit l'alimentation, conversion linéaire, bruit minimisé. Il est aussi bien sûr avantageux que le circuit de conversion ait une faible consommation.

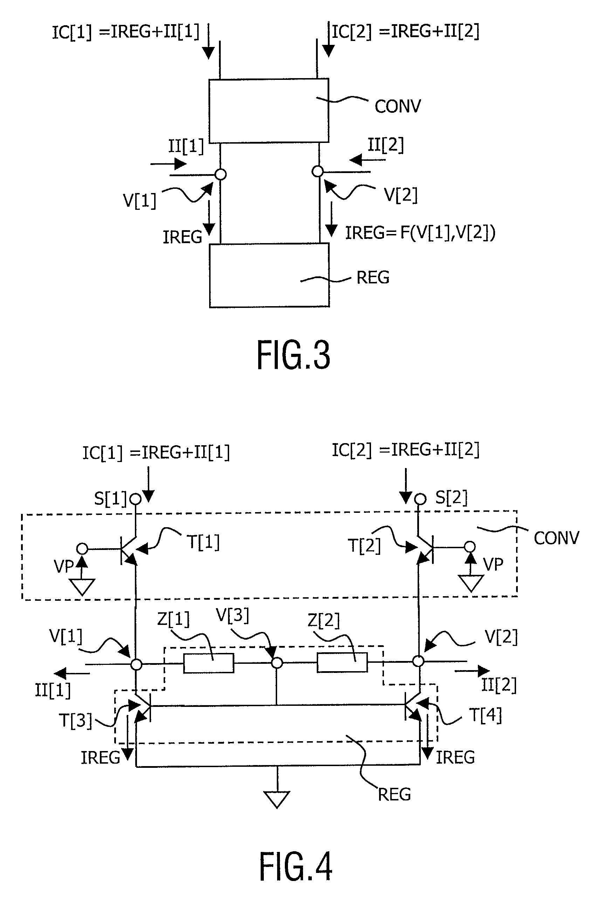

La figure 1 est un schéma d'un circuit de conversion CC tel qu'utilisé de manière standard. Une source de puissance P est une source de tension V avec une impédance de sortie ZO conséquente. A l'entrée du circuit de conversion, la tension est notée VI et le courant II. Le circuit de conversion présente alors une certaine impédance d'entrée ZI=VI/II. Pour obtenir un bon fonctionnement de la conversion, il faut alors que l'impédance d'entrée soit égale à ZO. Dans le cas d'une telle adaptation d'impédance où l'impédance d'entrée est constante, une conversion linéaire est obtenue. Dans la cellule de conversion CC standard présentée en exemple, un transistor T est relié par une première branche à une tension fixe VF, qui peut être nulle, par une deuxième branche à un noeud commun lui même relié d'une part à une source de courant de polarisation IO et d'autre part à une source de puissance P par l'intermédiaire d'une résistance R. La troisième branche du transistor constitue la sortie du circuit de conversion. Dans ce circuit de conversion, l'impédance d'entrée est définie par ZI=VI/II=R+1/GM, GM étant la transconductance du transistor T. Or GM n'est pas linéaire. En effet, la relation entre la tension base émetteur et l'intensité dans le collecteur n'est pas linéaire comme représenté sur la figure 4 et la tension à l'émetteur influe directement sur la valeur de II. Selon la figure 4, la valeur de IO, courant de polarisation, influence directement l'excursion possible en intensité. En effet, plus IO est grand, plus la partie approximativement linéaire autour de IO est importante. On note sur la figure 4 que le problème de linéarité est critique pour les grandes valeurs de la valeur absolue de II, pour lesquelles I-|II| sont dans une partie non linéaire de la courbe. Ainsi, si on souhaite travailler à puissance d'entrée élevée, c'est-à-dire II élevée, il est nécessaire d'augmenter le courant de polarisation pour rester dans le domaine linéaire. Cela engendre une forte consommation.

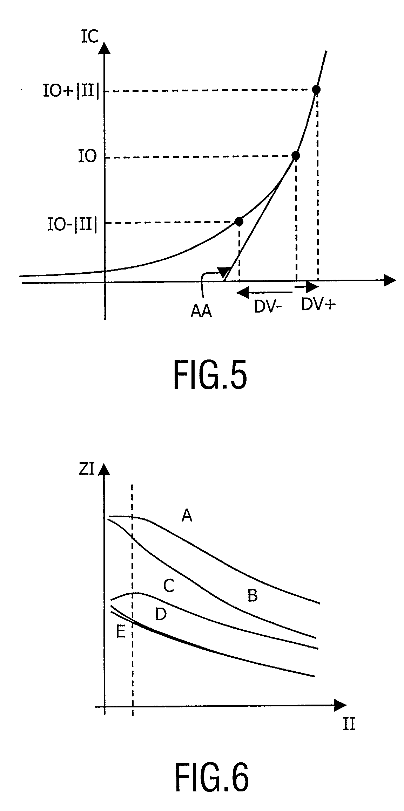

Cette contrainte a été contournée par B. Gilbert, dans le brevet de l'état de la technique cité, par un circuit de conversion différentiel représenté sur la figure 2. Cette cellule nécessite de disposer d'un signal différentiel composé de deux signaux II[1] et II[2] qui véhiculent l'information. En général, une structure différentielle est utilisée pour prendre en compte les alternances négatives du signal de forte puissance. Cependant nous allons voir que l'impédance d'entrée chute pour une telle structure. Les deux signaux II[1] et II[2] sont tels que II[2]=-II[1]=-II pour un fonctionnement correct de la cellule de conversion. De tels signaux différentiels viennent des circuits externes ou des blocs qui précèdent le circuit de conversion. Le courant de sortie différentiel est la différence entre les deux courants de sortie. Dans le cas de la cellule de B. Gilbert proposée, le courant de sortie différentiel est égal à 2II. Dans cette solution, le courant d'entrée II[1], respectivement II[2], passe en partie par T[1], respectivement T[2] pendant son alternance positive et par D[1], respectivement D[2], et recopié par un miroir de courant pendant son alternance négative. Cela revient à mettre deux circuits en parallèle pour lesquels le courant passe dans celui qui possède la plus faible impédance. Pour récupérer le courant de sortie quand celui-ci est dans son alternance négative, des miroirs de courant sont mis en oeuvre à l'aide des transistors T[3] et T[4] et les courants traversant ces transistors est fourni en sortie. Sur la figure 5, le fonctionnement de cet état de la technique est illustré par la droite AA qui remplace la courbe de polarisation du transistor durant l'alternance négative. Une bonne linéarité est en effet obtenue. L'ensemble des transistors T[3] et T[4] et des diodes D[1] et D[2] sont des moyens de régulation de l'impédance d'entrée qui permettent d'en améliorer la linéarité en proposant deux chemins pour les courants d'entrée. Cependant, cette amélioration utilisant des diodes et des transistors, la conversion subit encore l'influence des variations de transconductances non linéaires. Ainsi l'impédance d'entrée chute des deux côtés lorsque la puissance d'entrée est augmentée, à cause même de la structure des transistors. Par conséquent, l'impédance chute quand la puissance d'entrée augmente, cela est gênant à forte puissance car cela signifie que l'impédance du circuit n'est plus adaptée à celle de la source de puissance d'entrée. Cela est illustré sur la figure 6 qui propose une comparaison des propriétés d'un type de circuit de conversion selon l'état de la technique et selon l'invention. La courbe B représente l'impédance d'entrée de la cellule selon l'état de la technique. On note bien que l'impédance d'entrée chute quand la puissance augmente.

La figure 3 est un diagramme schématique de l'invention. Le circuit inclut ainsi des moyens de conversion CONV pour convertir le signal de puissance différentiel en courant différentiel. Les deux composantes du signal de puissance différentiel sont caractérisées par une intensité II[i] et un potentiel V[i] i=1 ou 2. Les moyens de conversion sont reliés aux première et seconde sorties S[i] du circuit de conversion pour fournir en sortie du circuit les composantes du courant différentiel de sortie : IC[1] et IC[2]. Le circuit inclut aussi des moyens de régulation REG de l'impédance d'entrée du circuit. Selon l'invention, les moyens de régulation incluent des moyens de contre-réaction pour contrôler un courant de régulation soustrait à chaque composante du signal de puissance en fonction des valeurs des potentiels aux premier et second noeuds communs, V[1] et V[2]. Cela est illustré sur la figure 3 par le courant IREG égal à une fonction F(V[1],V[2]) et extrait de II[1] et II[2] afin de réguler la conversion réalisée au sein des moyens de conversion CONV. La soustraction d'un courant de régulation aux composantes du signal de puissance permet d'augmenter l'impédance d'entrée du côté de l'alternance négative alors qu'elle diminue du côté de l'alternance positive où la régulation n'a que peu d'influence sur la valeur de l'impédance d'entrée. Comme le circuit fonctionne en différentiel, les deux phénomènes se compensent laissant l'impédance globale constante.
Avantageusement les moyens de contre-réaction utilisent une valeur moyenne des deux tensions aux premiers et second noeuds communs (V[1]+V[2])/2 pour déterminer la partie des signaux d'entrée qui sera absorbée par les moyens de régulation.

La figure 4 montre un mode de réalisation avantageux d'un circuit de conversion selon l'invention. Dans les explications, II[1] sera considéré positif et II[2]=-II[1]. Par conséquent, l'alternance positive se trouve du côté de T[1] et l'alternance négative se trouve du côté de T[2]. On rappelle ici que le signal de puissance est généralement alternatif. Le circuit de conversion d'un signal différentiel composé d'un premier signal II[1] et d'un second signal II[2] en un courant de sortie différentiel composé d'un premier courant IC[1] et d'un second courant IC[2] inclut une première sortie S[1] fournissant le premier courant IC[1] et une seconde sortie S[2] fournissant le second courant IC[2]. Un premier transistor T[1] présente une première branche couplée à la première sortie S[1], une seconde branche couplée à un signal de polarisation VP et une troisième branche couplée à un premier noeud commun où la tension est notée V[1], et qui reçoit le premier signal II[1]. Un second transistor T[2] présente une première branche couplée à la seconde sortie S[2], une seconde branche couplée à un signal de polarisation VP et une troisième branche à un second noeud commun où la tension est notée V[2], et qui reçoit le second signal II[2]. Ceci est commun à l'état de la technique. Les signaux de polarisation VP sont des signaux fixes destinés à mettre les transistors dans une zone de fonctionnement souhaité. Dans l'invention, la linéarité de conversion est obtenue par des moyens de conversion et de régulation réalisés à l'aide plusieurs transistors agencés d'une manière proche de celle décrite sur la figure 4 pour laquelle certains d'entre eux sont bouclés pour réaliser une contre-réaction. Dans ce cas, la contre-réaction régule dynamiquement les polarisations des moyens de conversion de manière à en déplacer les points de fonctionnement. Cela se fait préférentiellement par application d'un potentiel de contre-réaction à un transistor qui fonctionne en générateur de courant.
Plus particulièrement, un mode de réalisation préféré décrit sur la figure 4 utilise une contre-réaction de mode commun. Cette contre-réaction nécessite l'évaluation d'une valeur moyenne entre deux valeurs de potentiels puis utilise cette valeur moyenne pour réguler le courant de régulation IREG. Pratiquement, la contre-réaction est avantageusement réalisée au moyen d'un premier transistor de régulation T[3] ayant une première branche couplée au premier noeud commun, une seconde branche couplée à un troisième noeud commun où la tension est notée V[3], tension de mode commun, une troisième branche couplée à une tension de référence et d'un second transistor de régulation T[4] ayant une première branche couplée au second noeud commun, une seconde branche couplée au troisième noeud commun, une troisième branche couplée à la tension de référence (masse par exemple). Le troisième noeud commun est relié aux premier et second noeuds communs afin de réaliser la contre-réaction. Pratiquement, au moins un premier composant passif Z[1] est couplé entre le premier et le troisième noeud commun et au moins un second composant passif Z[2] est couplé entre le second et le troisième noeud commun. Lorsque ces composants passifs présentent les mêmes caractéristiques, la tension de mode commun [3] est la valeur moyenne (V[1]+V[2])/2 entre les deux tensions V[1] et V[2]. Les valeurs relatives de Z[1] et Z[2] peuvent permettre de jouer sur la régulation. Cependant le circuit étant par ailleurs symétrique et le signal d'entrée généralement alternatif, il est avantageux que le mode commun soit tel que Z[1]=Z[2]. Dans ce cas, lorsque II augmente, la tension V[2] au second noeud commun monte beaucoup plus vite que la tension V[1] au premier noeud commun à cause de la caractéristique non linéaire tension-courant des transistors (par exemple exponentielle dans le cas des transistors bipolaires). Par exemple, on note qu'en effet, sur la figure 5, DV- est supérieur à DV+. On remarque que le signal d'entrée étant un signal de puissance, une modification en conséquence du courant II[2] (c'est-à-dire, ici, du côté de l'alternance négative) est observée. Ainsi dès lors que V[2] est détecté différent de -V[1], il s'ensuit une correction mise en oeuvre par une variation de la tension de mode commun V[3] au troisième noeud commun. Cette tension est utilisée pour contre-réagir par la liaison à une branche de chacun des transistors T[3] et T[4]. Selon la figure 4, la base de ces transistors est effectivement reliée au troisième noeud commun V[3] et le courant IREG circulant dans ces transistors est donc directement régulé par cette contre-réaction sur les bases de ces transistors. IREG est alors égal à K(V[1],V[2])*IO+|II|. K étant un coefficient régulateur artificiel fonction du décalage de polarisation induit par la contre-réaction. Ce coefficient de régulation dépendra des propriétés des transistors T[3] et T[4]. L'invention utilise donc la non-linéarité elle-même pour corriger l'impédance d'entrée. Cette correction ne fonctionne que lorsque que l'on sort de la linéarité, c'est-à-dire à forte puissance. En fait, l'invention permet de se déplacer sur la courbe de la figure 5 alors que dans l'état de la technique, une autre courbe de fonctionnement est rattachée à celle des transistors en mettant deux circuits en parallèle. Il est remarquable de noter que le courant IREG étant le même des deux côtés du circuit, cela n'influence pas la sortie différentielle.
Dans le cas d'une cellule de conversion standard, c'est-à-dire sans contre-réaction de mode commun, lorsque II augmente, le courant traversant T[2] diminue à la même vitesse que II jusqu'à être nul. La limite de fonctionnement se situe à II=IO. Sur le graphique de la figure 5, une augmentation importante de l'impédance du côté alternance négative est en effet obtenue pour un fort II. Avec la contre-réaction, comme la régulation augmente (car V[3] augmente) quand II augmente, le courant dans T[3] et T[4] augmente également. Ainsi l'alternance négative du courant d'entrée II[2] est absorbée par T[4]. Dans ce cas, T[2] reste polarisée pour un II bien supérieur à IO et permet de maintenir l'impédance d'entrée à la valeur voulue. L'amélioration de la linéarité de l'impédance d'entrée vient du fait que lorsque II augmente, l'impédance d'entrée du côté de T[1] chute, car l'Intensité dans T[1] augmente, mais celle du côté de T[2] augmente, car l'intensité dans T[2] diminue. L'impédance différentielle étant la somme des deux impédances, les deux effets se compensent réduisant ainsi la chute de l'impédance quand la puissance d'entrée augmente.

La figure 6 montre une comparaison à courant de polarisation équivalent de la nouvelle structure et de celle exposée dans le brevet US 6,104,225. Par polarisation équivalente, on entend ici que la tension de polarisation est générée de telle manière que l'impédance d'entrée est la même pour les deux structures. Dans les circuits, les tensions aux différents noeuds ainsi que les courants dans les composants sont fixés par des circuits de polarisation pour mettre les composants dans les zones de fonctionnement désirées. La consommation globale est identique pour les deux structures. La courbe A représente l'impédance d'entrée différentielle de la nouvelle structure, la courbe B celle de l'état de la technique. La courbe C est l'impédance d'entrée observée lors de l'alternance négative, la courbe E, celle observée lors de l'alternance positive pour la nouvelle structure proposée par l'invention. Enfin, la courbe D est l'impédance d'entrée d'un côté de la structure de l'état de la technique qui est la même pour les alternances positives et négatives. On remarque que la chute de l'impédance étant retardée lors de l'alternance négative par une première augmentation suivie d'une diminution, l'impédance différentielle de l'ensemble, qui est la somme des courbes C et E, chute moins vite. Ainsi à courant de polarisation équivalent, les deux structures ont les même performances en terme de linéarité de conversion mais la nouvelle structure démontre une meilleure linéarité en terme d'impédance d'entrée.

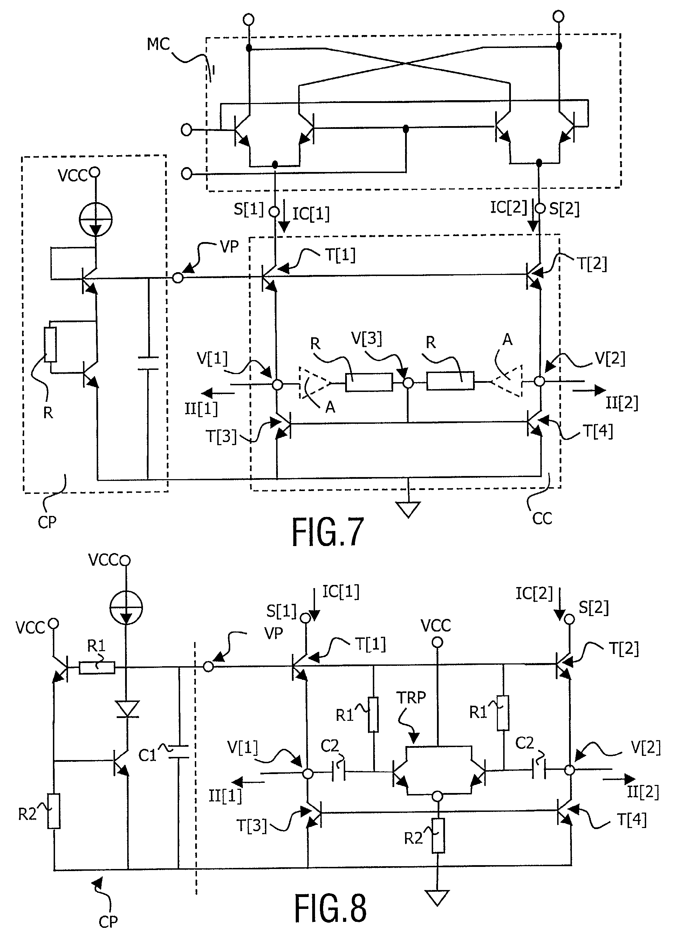

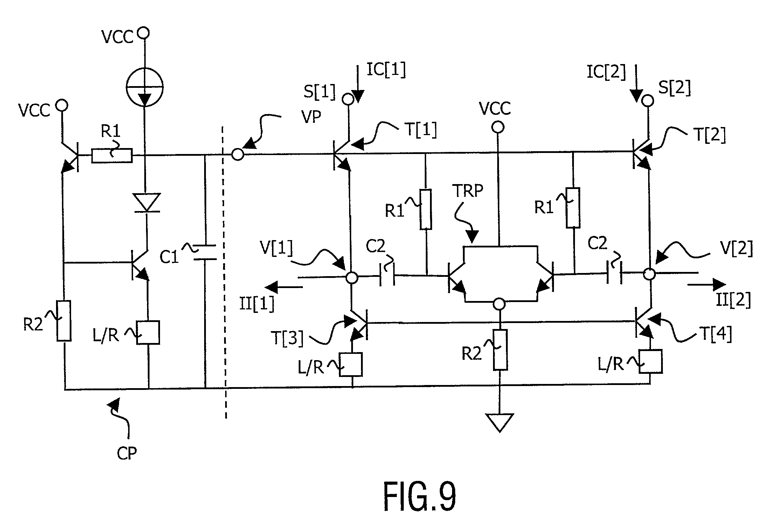

La figure 7 est un mode de réalisation très simple de l'invention pour lequel les impédances Z[1] et Z[2] de la figure 4 sont des résistances R et pour lequel un circuit classique de polarisation CP est relié au circuit de conversion pour lui fournir la tension de polarisation VP. Le circuit de polarisation est connecté à une tension de référence VCC. La figure 7 décrit également un mélangeur selon l'invention. Un tel mélangeur de signaux inclut un étage d'entrée CC incluant au moins un circuit de conversion tel que décrit auparavant, un étage de mélange MC et un étage de polarisation CP fournissant un signal de polarisation VP à l'étage d'entrée CC, l'étage d'entrée CC recevant un signal d'entrée différentiel II[1] et II[2] et ayant une première sortie S[1] fournissant un premier courant IC[1] à une première entrée de l'étage de mélange MC et une seconde sortie S[2] fournissant un second courant IC[2] à une seconde entrée de l'étage de mélange MC. Dans ce mode de réalisation, existe un bruit différentiel qui apparaît dans les signaux différentiels de sortie. En effet les résistances R utilisées pour prélever le mode commun injectent du bruit sur les entrées différentielles du circuit qui véhiculent II[1] et II[2]. Ce bruit est conservé sur la sortie différentielle.
Il peut être avantageux de minimiser encore le bruit dans la contre-réaction. On peut simplement ajouter sur le circuit de la figure 4, des amplificateurs A entre les résistances R et les premier et second noeuds communs. Ces amplificateurs permettent d'isoler la résistance de l'entrée du circuit de conversion, c'est-à-dire des premier et second noeuds communs. Ces amplificateurs sont facultatifs et donc notés en pointillés sur la figure 4.
D'autre part, les modes de réalisation des figures 8 et 9 sont proposés. En terme de bruit, le prélèvement du mode commun utilisant une paire de transistors TRP est une solution avantageuse. Dans les figures 8 et 9, les circuits de polarisation CP sont adaptés en fonction du circuit de conversion : ils fournissent aux transistors du circuit de conversion la polarisation nécessaire pour un fonctionnement correct, ceci à partir d'une tension de référence VCC. Cette adaptation est connue de l'homme du métier. Les résistances R1 permettent de fixer le potentiel continu des bases des transistors, les éléments R1 et C2 forment des filtres passe-haut dont les entrées sont les entrées différentielles et la sortie la base des transistors. R2 sert à fixer le courant à travers les transistors de la paire. En continu, les bases des transistors sont donc fixées à la tension de polarisation et en fonctionnement fréquentiel (fréquence des signaux d'entrée) elles sont connectées aux entrées différentielles car la capacité C2 se comporte comme un court-circuit en haute fréquence et comme un circuit ouvert en continu. L'essentiel du bruit est alors injecté vers le troisième noeud commun et donc vers la base des transistors T[3] et T[4] des moyens de régulation. Le bruit n'apparaît donc pas dans la sortie en mode différentiel. Les éléments cités pour minimiser le bruit : amplificateur, transistor, condensateur peuvent être utilisés seuls ou en combinaison entre eux.

La figure 9 propose d'appliquer une dégénération inductive-résistive L/R permettant de minimiser encore le bruit des transistors selon des concepts connus de l'homme du métier.
Les figures présentées concernent des modes de réalisation particuliers de l'invention. Bien que cette invention ait été décrite en accord avec les modes de réalisation présentés, un homme du métier reconnaîtra immédiatement qu'il existe des variantes aux modes de réalisation présentés et que ces variantes restent dans l'esprit et sous la portée de la présente invention. Il existe de nombreuses façons de mettre en oeuvre l'invention et de nombreuses modifications peuvent être réalisées par un homme du métier sans pour autant s'exclure de l'esprit et de la portée définis par les revendications suivantes.

## Revendications

1. Circuit de conversion pour convertir un signal de puissance différentiel composé d'un premier signal fourni à un premier noeud commun et d'un second signal fourni à un second noeud commun, en un courant de sortie différentiel composé d'un premier et d'un second courant, ledit circuit incluant une première sortie fournissant le premier courant, une seconde sortie fournissant le second courant,
ledit circuit incluant :
des moyens de conversion pour convertir le premier et le second signal en le premier et le second courant respectivement, lesdits moyens de conversion étant reliés aux première et
seconde sorties du circuit de conversion,
des moyens de régulation de l'impédance d'entrée du circuit reliés aux moyens de conversion,
**caractérisé en ce que** les moyens de régulation incluent des moyens de contre-réaction pour contrôler un courant de régulation soustrait à chaque composante du signal de puissance en fonction des valeurs des potentiels aux premier et second noeuds communs.

2. Circuit de conversion selon la revendication 1, **caractérisé en ce que** les moyens de contre-réaction régulent le courant de régulation en fonction d'une valeur moyenne des potentiels aux premiers et seconds noeuds communs.

3. Circuit de conversion selon l'une des revendications 1 et 2, tel que les moyens de conversion incluent :
un premier transistor de conversion ayant une première branche couplée à la première sortie, une seconde branche couplée à un signal de polarisation et une troisième branche couplée au premier noeud commun pour recevoir le premier signal,
un second transistor de conversion ayant une première branche couplée à la seconde sortie, une seconde branche couplée au signal de polarisation et une troisième branche couplée au second noeud commun pour recevoir le second signal.

4. Circuit de conversion selon l'une des revendications 1 à 3, **caractérisé en ce que** les moyens de régulation incluent :
un premier transistor de régulation ayant une première branche couplée au premier noeud commun, une seconde branche couplée à un troisième noeud commun, une troisième branche couplée à une tension de référence,
un second transistor de régulation ayant une première branche couplée au second noeud commun, une seconde branche couplée au troisième noeud commun, une troisième branche couplée à la tension de référence,
le troisième noeud commun étant relié à chacun des premier et second noeuds communs pour réaliser la contre-réaction.

5. Circuit de conversion tel que revendiqué dans la revendication 4, **caractérisé en ce que** les liaisons entre le troisième et premier noeud commun et entre le troisième et second noeud commun incluent des éléments destinés à minimiser le bruit dans ces liaisons.

6. Circuit de conversion tel que revendiqué dans la revendication 5, **caractérisé en ce que** les éléments destinés à diminuer le bruit dans ces liaisons sont choisis parmi les éléments suivants : amplificateur, transistor, condensateur, seuls ou en combinaison entre eux.

7. Circuit de conversion tel que revendiqué dans l'une des revendications 4 à 6, **caractérisé en ce qu'**une dégénération inductive et/ou résistive est réalisée sur les premiers et seconds transistors de régulation.

8. Mélangeur de signaux incluant un étage d'entrée, un étage de mélange et un étage de polarisation fournissant un signal de polarisation à l'étage d'entrée, l'étage d'entrée recevant un signal d'entrée différentiel et ayant une première sortie fournissant un premier courant à une première entrée de l'étage de mélange et une seconde sortie fournissant un second courant à une seconde entrée de l'étage de mélange, **caractérisé en ce que** l'étage d'entrée inclut un circuit de conversion tel que revendiqué dans l'une des revendications 1 à 7.

9. Appareil de traitement de signaux incluant au moins un mélangeur de signaux selon la revendication 8.

10. Récepteur de signaux incluant un appareil de traitement de signaux selon la revendication 9.
